# EUROPEAN PATENT SPECIFICATION

(11) **EP 1 153 393 B1**
(45) Date of publication and mention of the grant of the patent: **24.05.2006**
(21) Application number: 99905656.7
(22) Date of filing: 02.02.1999
(51) Int. Cl.: G11C 7/00, G11C 5/14

(54) **IMPROVED WORD LINE BOOST CIRCUIT**
VERBESSERTE SPANNUNGSERHÖHUNGSSCHALTUNG FÜR WORTLEITUNG
CIRCUIT D'AMPLIFICATION DE CANAL MOT AMELIORE

(43) Date of publication of application: 14.11.2001
(73) Proprietor: MACRONIX INTERNATIONAL CO., LTD., Hsinchu (TW)
(72) Inventor: LIN, Yu Shen, Taiwan 104 (TW); HUNG, Chun-Hsiung, Hsinchu, Taiwan 300 (TW); WAN, Ray-Lin, Fremont, CA 94539 (US)
(74) Representative: Horner, David Richard
(86) International application number: PCT/US1999/002260
(87) International publication number: WO 2000/046807

(56) References cited:
- US-A- 4 769 792
- US-A- 5 347 488
- US-A- 5 708 387
- US-A- 5 748 032
- US-A- 5 751 643

## Description

### BACKGROUND OF THE INVENTION

### Field of the Invention

This invention relates to the field of voltage boost circuits. In particular, the invention relates to integrated circuits using word line boost circuits to produce on-chip voltages outside the range of the off-chip voltage supply.

### Description of the Related Art

The electronics industry has continued to define standard power supply voltages of decreasing magnitudes. Decreasing power supply voltages, such as 5 volts, 3 volts, and 1.8 volts, raise the demands on modem circuits to provide sufficiently high on-chip voltages despite a lower off-chip supply voltage. Flash memory is an example of an application that would welcome more efficient boosting of a low off-chip supply voltage to an on-chip voltage sufficiently high to access flash memory cells. Therefore, what is needed is a word line boost circuit having higher boosting efficiency.

US 5,708,387 describes a voltage booster circuit as indicated in the preamble of claim 1. It incorporates two driver circuits which are used in parallel, and at the same time, to reduce the voltage variation of the produced word line voltage and the overall power dissipation of the voltage booster circuit. US 4,769,792 describes a semiconductor memory device which includes two or more voltage bootstrap circuits that are sequentially operated in order to enable a continuous data write/read operation to be performed at a high speed.

### SUMMARY OF THE INVENTION

Particular and preferred aspects of the present invention are set out in the accompanying independent and dependent claims.

An improved word line boost circuit is provided in one embodiment that increases boosting efficiency. The improved word line boost circuit can be implemented in an integrated circuit that includes a memory array with word lines powered by word line drivers. Boosting efficiency is increased by floating a part of a first circuit that initially boosts an output voltage of the word line boost circuit. Floating part of the first circuit obviates the need for a diode to isolate the first circuit, and decreases the load on a second circuit that further boosts the output voltage of the word line boost circuit, thereby increasing efficiency.

A boost circuit of one embodiment includes an output, a precharge circuit connected to the output, a first capacitor with a second terminal connected to the output, a first circuit connected to a first terminal of the first capacitor, a second capacitor, and a second circuit connected to the output through the second capacitor. The first terminal of the first capacitor can be in a floating state, set to a first supply voltage, or a second supply voltage. An onset of a first boost operation performed by the first circuit is followed after a time delay by an onset of a second boost operation performed by the second circuit.

In some embodiments, one of the first supply voltage and the second supply voltage is a ground; the precharge circuit has a switching circuit connected to the output of the first voltage supply and the second voltage supply; and the first terminal of the first capacitor switches between i) a floating state, ii) being set to a first supply voltage, and iii) being set to a second supply voltage in response to one or both of a first signal and a second signal.

In a further embodiment, the word line boost circuit is part of an integrated circuit device with a substrate. In yet another embodiment, the word line boost circuit is part of an integrated circuit memory device with a substrate, a memory array, and word lines.

A method for reducing energy consumption of a boost circuit to achieve higher boosting efficiency for the above mentioned word line boost circuit comprises in one embodiment: precharging an output to a precharge voltage, changing the output to a first voltage with a first coupling circuit that is connected to the output, floating a part of the first coupling circuit, and changing the output to a second voltage with a second coupling circuit connected to the output.

In some embodiments, the method for reducing energy consumption of a boost circuit to achieve higher boosting efficiency for the above mentioned word line boost circuit comprises: changing an output from a precharge voltage to a first voltage with a first circuit, setting a node in the first circuit to a floating voltage, and changing the output from the first voltage to a second voltage with an energy expenditure that is lower than if the node were not floating.

### BRIEF DESCRIPTION OF THE FIGURES

Figure 1 is a block diagram of a word line boost circuit.
Figure 2 is a circuit diagram of a precharge circuit.
Figure 3 is a circuit diagram of a first boost circuit.
Figure 4 is a circuit diagram of a second boost circuit.
Figure 5 is a block diagram of a word line boost circuit representing an embodiment of the invention.
Figure 6 is a circuit diagram of a precharge circuit.
Figure 7 is a circuit diagram of a first boost circuit.
Figure 8 is a circuit diagram of a second boost circuit.
Figure 9 is a timing diagram of a first signal and a second signal supplied to a word line boost circuit.
Figure 10 is a timing diagram of voltages supplied by word line boost circuits representing embodiments of the invention.
Figure 11 is a simplified block diagram of an integrated circuit utilizing an improved word line boost circuit.

### DETAILED DESCRIPTION

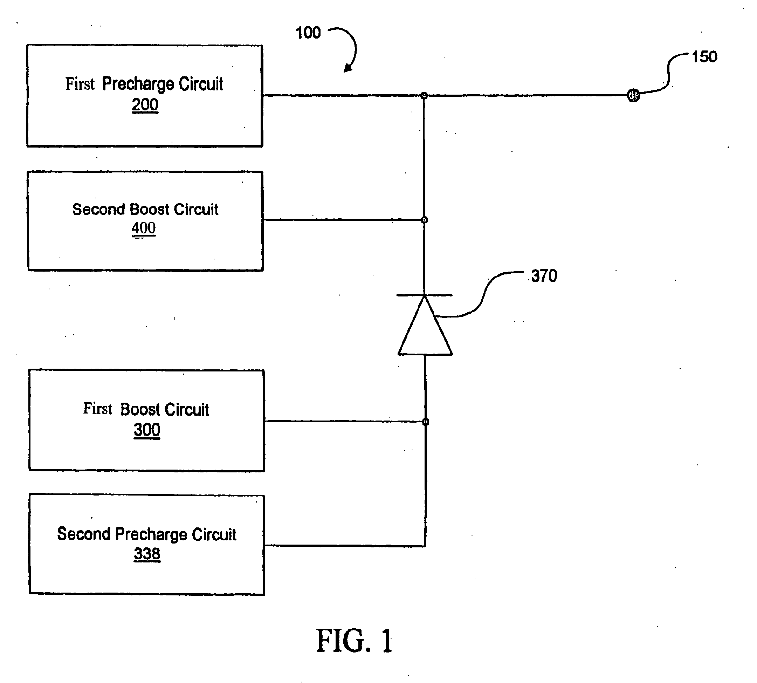

Figure 1 illustrates a word line boost circuit 100. The word line boost circuit 100 includes a first precharge circuit 200, a first boost circuit 300, a second precharge circuit 338, a diode 370, a second boost circuit 400, and an output 150. The first precharge circuit 200 and the second precharge circuit 338 each serves as a node charging circuit that charges a node from a starting voltage to another voltage.

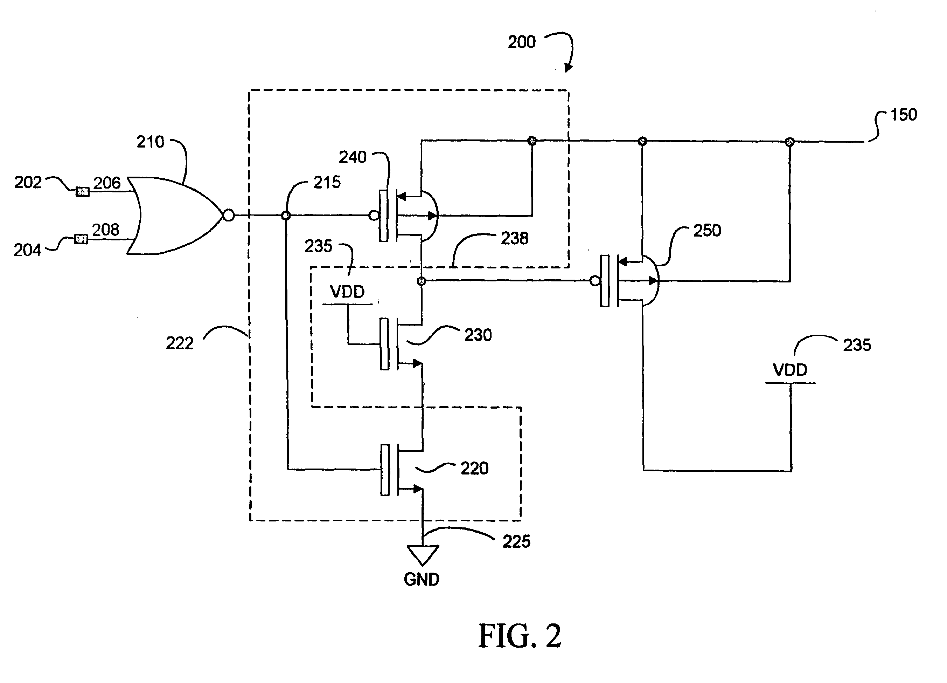

Figure 2 schematically illustrates the first precharge circuit 200. The first precharge circuit 200 includes a NOR gate 210, a first transistor 220, a second transistor 230, a third transistor 240, and a switching transistor 250. Switch circuit 222 includes the first transistor 220 and the third transistor 240. The NOR gate 210 has a first input terminal 202 receiving a first signal 206, a second input terminal 204 receiving a second signal 208, and an output connected to a node 215. The first transistor 220 is an n-channel transistor with a gate connected to the node 215, a source connected to a ground 225, and a drain. The second transistor 230 is an n-channel transistor with a gate connected to a voltage supply 235, a source connected to the drain of the first transistor 220, and a drain connected to a node 238. Node 238 is the output node of the switch circuit 222. The third transistor 240 is a p-channel transistor with a gate connected to the node 215, a source connected to the output 150, and a drain connected to the node 238. The switching transistor 250 is a p-channel transistor with a gate connected to the node 238, a source connected to the output 150, and a drain connected to the voltage supply 235. The first precharge circuit 200 charges the output 150 to the voltage of the voltage supply 235. The first precharge circuit 200 then floats the output 150.

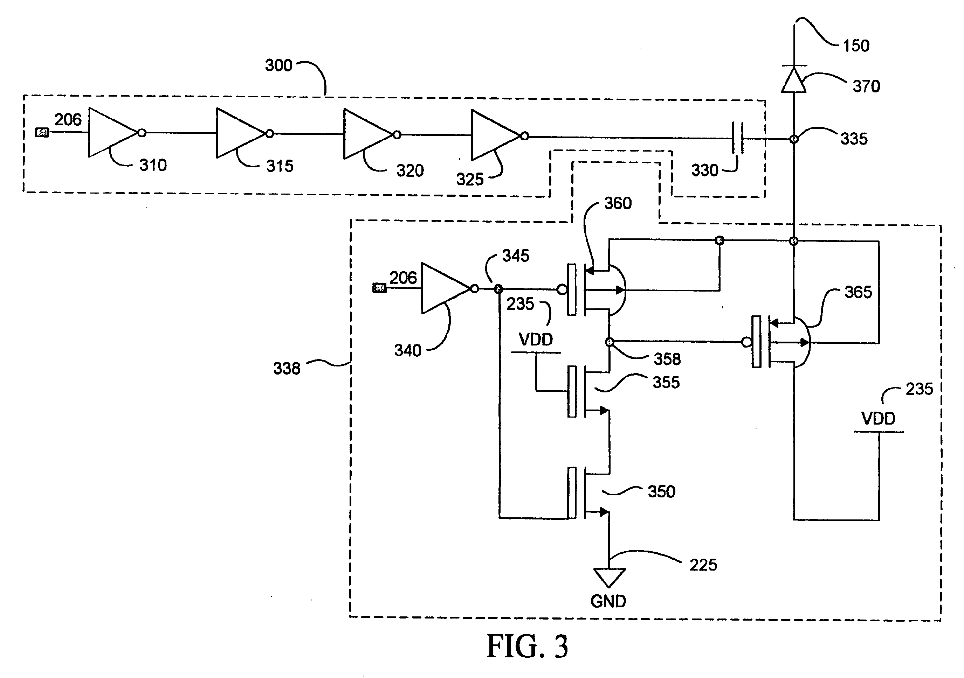

Figure 3 schematically illustrates the first boost circuit 300, the diode 370, and the second precharge circuit 338. The first boost circuit 300 includes a first inverter 310. a second inverter 315, a third inverter 320, a fourth inverter 325, and a first capacitor 330. The second precharge circuit 338 includes a fifth inverter 340, a fourth transistor 350, a fifth transistor 355, a sixth transistor 360, and a seventh transistor 365. The second precharge circuit 338 charges a node 335 to the voltage of the voltage supply 235. The second precharge circuit 338 then floats the node 335.

An input of the first inverter 310 receives the first signal 206. The first inverter 310, the second inverter 315, the third inverter 320, and the fourth inverter 325 are connected in series. The first capacitor 330 has a first terminal connected to an output of the fourth inverter 325, and a second terminal connected to the node 335. The fifth inverter 340 has an input that receives the first signal 206, and an output that is connected to a node 345. The fourth transistor 350 is an n-channel transistor with a gate connected to the node 345, a source connected to the ground 225, and a drain. The fifth transistor 355 is an n-channel transistor with a gate connected to the voltage supply 235, a source connected to the drain of the fourth transistor 350, and a drain connected to a node 358. The sixth transistor 360 is a p-channel transistor with a gate connected to the node 345, a source connected to the node 335, and a drain connected to the node 358. The seventh transistor 365 is a p-channel transistor with a gate connected to the node 358, a source connected to the node 335, and a drain connected to the voltage supply 235. The diode 370 has a first terminal connected to the node 335 and a second terminal connected to the output 150.

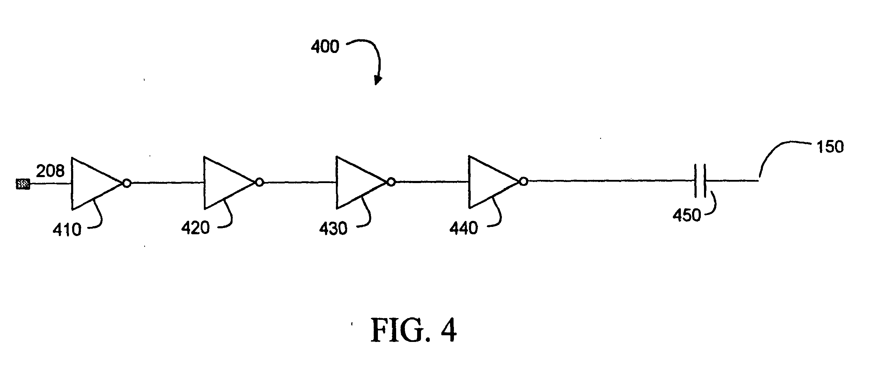

Figure 4 schematically illustrates the second boost circuit 400. The second boost circuit 400 includes a sixth inverter 410, a seventh inverter 420, an eighth inverter 430, a ninth inverter 440, and a second capacitor 450. An input of the sixth inverter 410 receives the second signal 208. The sixth inverter 410, the seventh inverter 420, the eighth inverter 430, and the ninth inverter 440 are connected in series. The second capacitor 450 has a first terminal connected to an output of the ninth inverter 440 and a second terminal connected to the output 150.

When the word line boost circuit 100 operates, the first precharge circuit 200 and the second precharge circuit 338 precharge both terminals of the diode 370. The first precharge circuit 200 and the second precharge circuit 338 float both terminals of the diode 370. The first boost circuit 300 boosts the first terminal of the diode 370. The second boost circuit 400 boosts the second terminal of the diode 370, or the output 150.

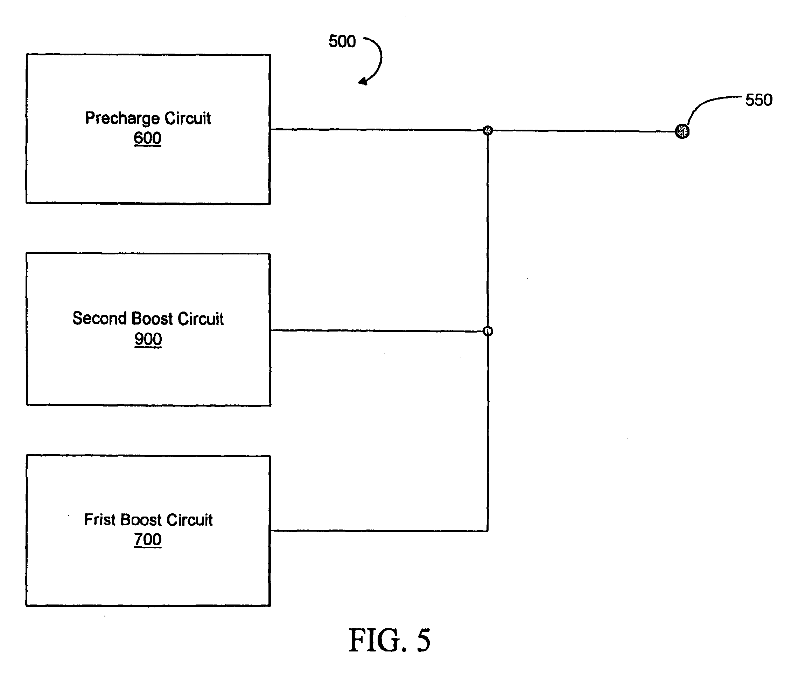

Figure 5 illustrates a word line boost circuit 500. The word line boost circuit 500 includes a precharge circuit 600, a first boost circuit 700, a second boost circuit 900, and an output 550.

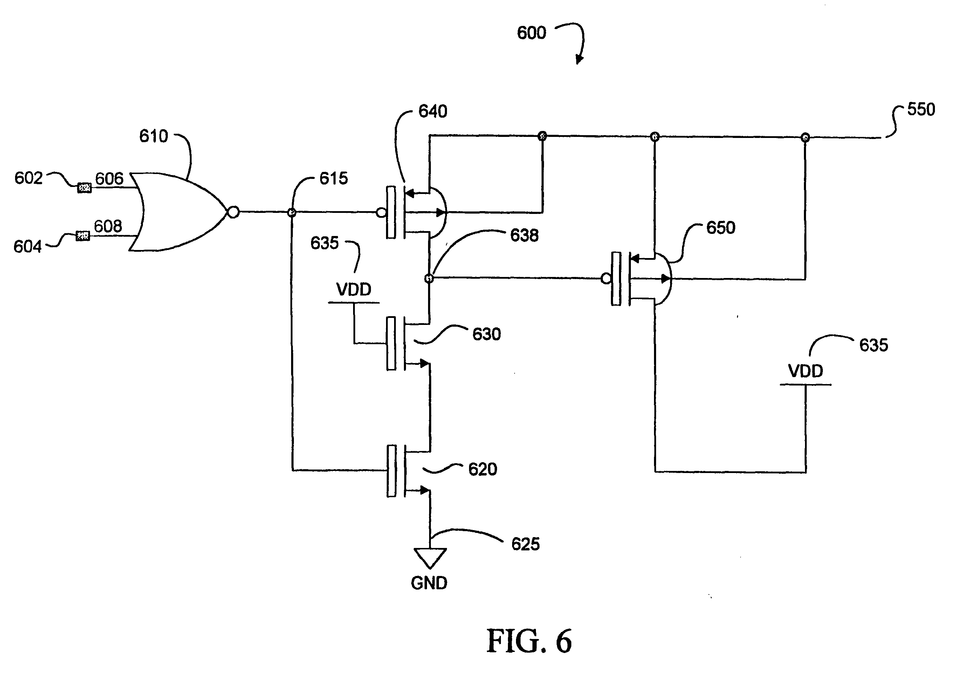

Figure 6 schematically illustrates the precharge circuit 600. Transistors having a thick gate oxide are indicated with a rectangle for a gate. The oxide thicknesses for thick gate oxide devices and thin gate oxide devices are 180 Å and 100 Å respectively for 0.4 micron technology. The precharge circuit 600 includes a first NOR gate 610, a first transistor 620, a second transistor 630, a third transistor 640, and a switching transistor 650. The first NOR gate 610 has a first input terminal 602 receiving a first signal 606, a second input terminal 604 receiving a second signal 608, and an output connected to a node 615. The first transistor 620 is an n-channel transistor with a thick gate oxide having a gate connected to the node 615, a source connected to a ground 625, and a drain. The second transistor 630 is an n-channel transistor with a thick gate oxide having a gate connected to a voltage supply 635, a source connected to the drain of the first transistor 620, and a drain connected to a node 638. The third transistor 640 is a p-channel transistor with a thick gate oxide having a gate connected to the node 615, a source connected to the output 550, and a drain connected to the node 638. The switching transistor 650 is a p-channel transistor with a thick gate oxide having a gate connected to the node 638, a source connected to the output 550, and a drain connected to the voltage supply 635.

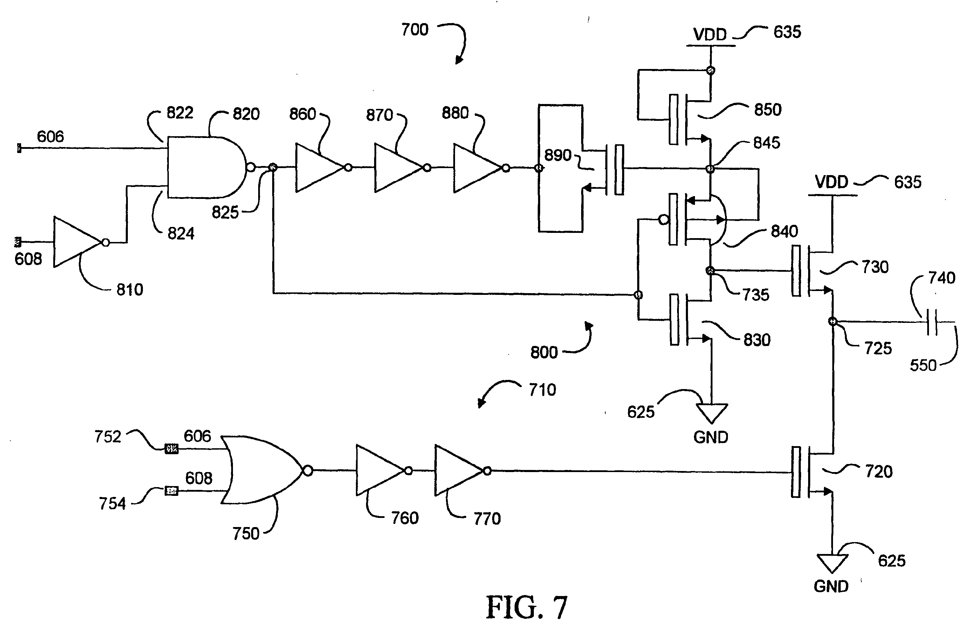

Figure 7 schematically illustrates the first boost circuit 700. Transistors having a thick gate oxide are indicated with a rectangle for a gate. The first boost circuit 700 includes a first branch 710, a fourth transistor 720, a fifth transistor 730, a first capacitor 740, and a second branch 800. The first branch 710 includes a second NOR gate 750, a first inverter 760, and a second inverter 770. The second branch 800 includes a third inverter 810, a first NAND gate 820, a sixth transistor 830, a seventh transistor 840, an eighth transistor 850, a fourth inverter 860, a fifth inverter 870, a sixth inverter 880, and a ninth transistor 890.

The second NOR gate 750 has a first input terminal 752 receiving the first signal 606 and a second input terminal 754 receiving the second signal 608. An output of the second NOR gate 750 is connected to an input of the first inverter 760. An output of the first inverter 760 is connected to an input of the second inverter 770. The fourth transistor 720 is an n-channel transistor with a thick gate oxide having a gate connected to an output of the second inverter 770, a source connected to the ground 625, and a drain connected to a node 725. The fifth transistor 730 is an n-channel transistor with a thick gate oxide having a gate connected to a node 735, a source connected to the node 725, and a drain connected to the voltage supply 635. The first capacitor 740 has a first terminal connected to the node 725 and a second terminal connected to the output 550. The third inverter 810 has an input receiving the second signal 608. The NAND gate 820 has a first input terminal 822 receiving the first signal 606, a second input terminal 824 connected to an output of the third inverter 810, and an output connected to a node 825. The sixth transistor 830 is an n-channel transistor 830 with a thick gate oxide having a gate connected to the node 825, a source connected to the ground 625, and a drain connected to the node 735. The seventh transistor 840 is a p-channel transistor with a thick gate oxide having a gate connected to the node 825, a drain connected to the node 735, and a source connected to a node 845. The eighth transistor 850 is a diode-connected n-channel transistor with a thick gate oxide having an anode connected to the voltage supply 635 and a cathode connected to the node 845. The fourth inverter 860 has an input connected to the node 825. The fifth inverter 870 has an input connected to an output of the fourth inverter 860. The sixth inverter 880 has an input connected to an output of the fifth inverter 870. The ninth transistor 890 is a capacitor-connected n-channel transistor with a thick gate oxide having a first terminal connected to an output of the sixth inverter 880 and a second terminal connected to the node 845.

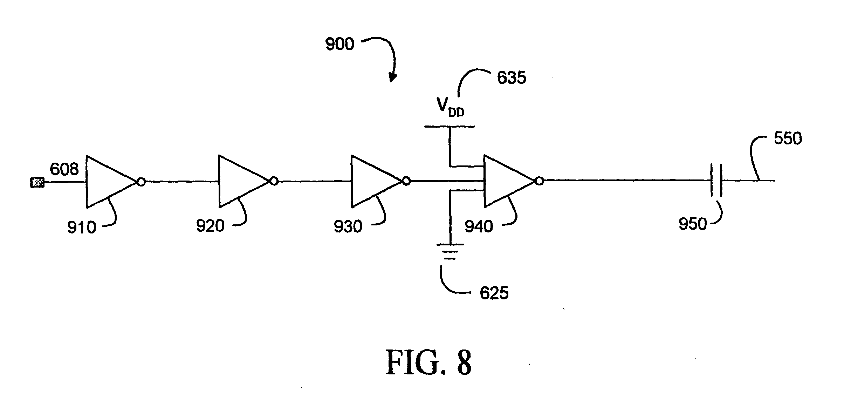

Figure 8 schematically illustrates the second boost circuit 900. The second boost circuit 900 includes a seventh inverter 910, an eighth inverter 920, a ninth inverter 930, a tenth inverter 940, and a second capacitor 950. An input of the seventh inverter 910 receives the second signal 608. The seventh inverter 910, the eighth inverter 920, the ninth inverter 930, and the tenth inverter 940 are connected in series. The second capacitor 950 has a first terminal connected to an output of the tenth inverter 940 and a second terminal connected to the output 550.

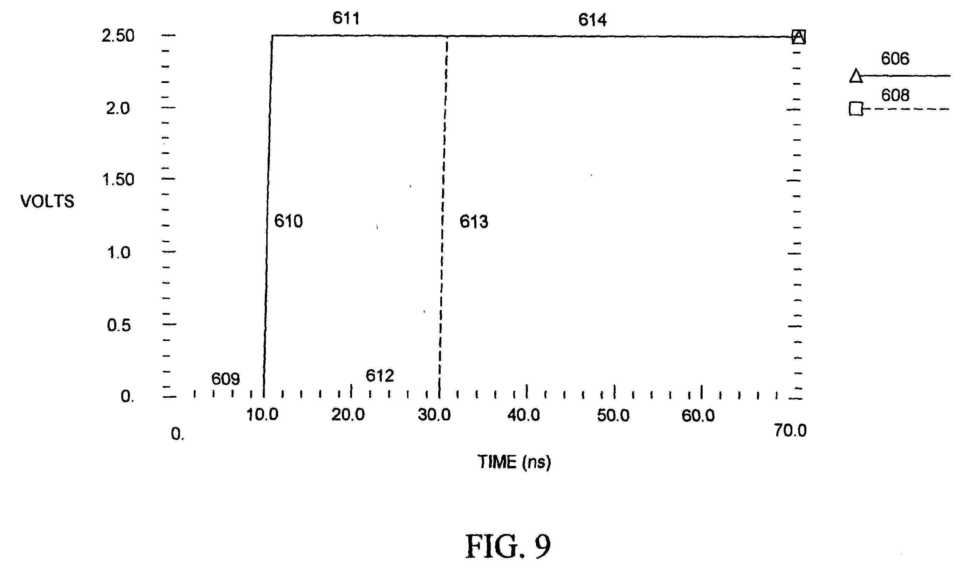

Figure 9 is a timing diagram displaying voltage versus time for the first signal 606 and the second signal 608. The first signal 606 has a low level 609, a rising edge 610 triggering an onset of a first boost operation, and a high level 611. The second signal 608 has a low level 612, a rising edge 613 triggering an onset of a second boost operation, and a high level 614.

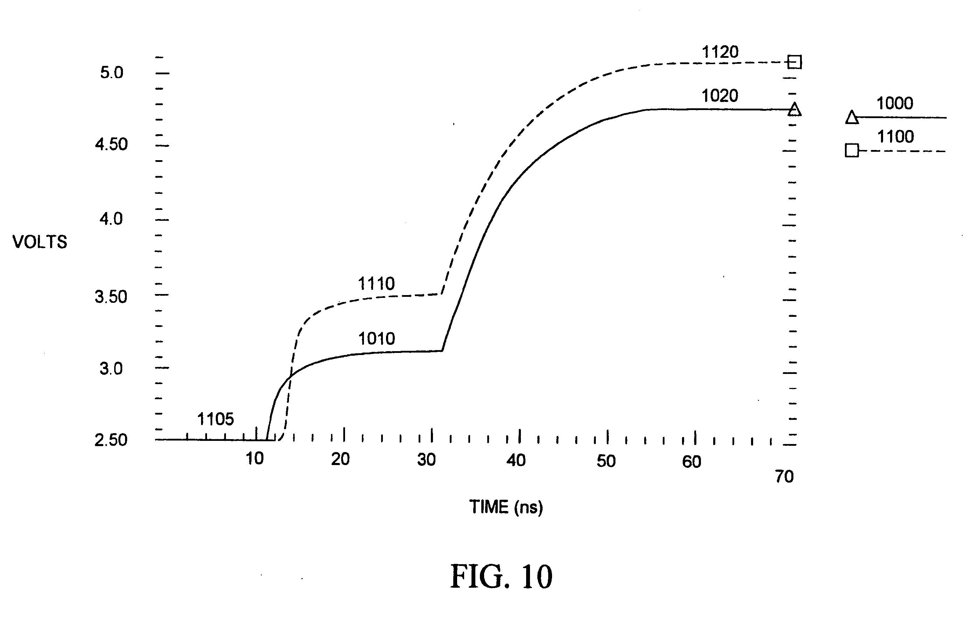

Figure 10 is a timing diagram displaying voltage versus time for an output signal 1000 supplied by the output 150 and an improved output signal 1100 supplied by the output 550. Output signal 1000 has a first level 1010 and a second level 1020. Improved output signal 1100 has a precharge level 1105, a first level 1110, and a second level 1120.

With reference to Figure 6-10, initially, the first signal 606 is at the low level 609 and the second signal 608 is at the low level 612. The precharge circuit 600 connects the output 550 to voltage supply 635 through the switching transistor 650. The improved output signal 1100 has the precharge level 1105 of 2.5 volts. The first branch 710 of the first boost circuit 700 turns on the fourth transistor 720 and the second branch 800 turns off the fifth transistor 730. The first terminal of the first capacitor 740 is connected to the ground 625 through the fourth transistor 720. The second boost circuit 900 connects the first terminal of the second capacitor 950 to the ground 625 through the tenth inverter 940.

The rising edge 610 of the first signal 606 triggers the onset of the first boost operation. In the precharge circuit 600, the switching transistor 650 turns off. The output 550 is no longer connected to the voltage supply 635. The first branch 710 of the first boost circuit 700 turns off the fourth transistor 720. The second branch 800 turns on the fifth transistor 730, connecting the voltage supply 635 to the first terminal of the first capacitor 740. Capacitive coupling through the first capacitor 740 raises the improved output signal 1100 to the first level 1110, yielding advantageous results. Specifically, the first level 1110 of the improved output signal 1100 is about 3.5 volts, about 0.3 volts higher than the first level 1010 of the output signal 1000. This difference is both of significant magnitude and sustained duration.

The rising edge 613 of the second signal 608 triggers the onset of the second boost operation. The second branch 800 turns off the fifth transistor 730. The first terminal of the first capacitor 740 floats. The second boost circuit 900 connects the first terminal of the second capacitor 950 to the voltage supply 635 through the tenth inverter 940. Capacitive coupling through the second capacitor 950 raises the improved output signal 1100 to the second level 1120, continuing to yield advantageous results. Specifically, the second level 1120 of the improved output signal 1100 is about 5.1 volts, about 0.3 volts higher than the second level 1020 of the output signal 1000. This difference between the second level 1120 and the second level 1020 is of significant magnitude and duration.

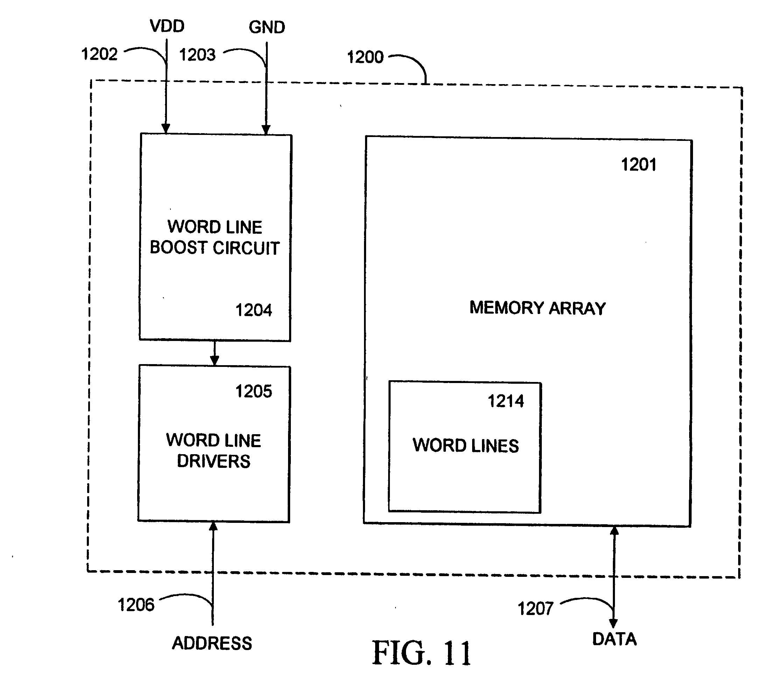

Figure 11 provides a simplified diagram of an integrated circuit device utilizing the word line boost circuit of the present invention. The integrated circuit 1200 includes a semiconductor substrate. A memory array 1201 on the substrate has word lines 1214 for accessing rows of memory cells in the memory array 1201. The word lines 1214 utilize an operating voltage which is outside a pre-specified range of a supply potential normally applied to the integrated circuit 1200 at supply terminals 1202 and 1203, which are adapted to receive a supply potential VDD and ground. The word line boost circuit 1204 supplies the operating potential to the word lines 1214 through word line drivers 1205. Input signals applied to the integrated circuit 1200 in this example include address signals 1206 applied to the word line drivers 1205 and data signals 1207.

Figure 11 is representative of a wide variety of integrated circuits which include on-chip circuitry that utilizes the operational voltage outside the pre-specified range of the supply potential. Memory devices such as flash memory devices are one class of integrated circuit devices according to the present invention.

Other embodiments of the invention can use different logic in one or more of the precharge branch, the first circuit, and the second circuit to process the signals triggering the onsets of the boosting operations. Another embodiment of the invention uses different signals triggering the onsets of the boosting operations, for example, signals going from high to low; one signal going from high to low and another signal going from low to high; and level triggering signals. Another embodiment of the invention is a word line boost circuit producing a boosted negative voltage.

The foregoing description of various embodiments of the invention have been presented for purposes of illustration and description. It is not intended to limit the invention to the precise forms disclosed. Many modifications and equivalent arrangements will be apparent.

## Claims

1. A boost circuit, comprising:
an output (550);
a precharge circuit (Fig. 6) connected to the output and operable to precharge the output to a precharge level (1105);
a first capacitor (740) having a first terminal and a second terminal, and the second terminal connected to the output;
a first circuit (Fig. 7) connected to the first terminal of the first capacitor, the first circuit defining one of a first state, a second state, and a third state, wherein in the first state the first terminal of the first capacitor is coupled to a first voltage supply, and in the second state the first terminal of the first capacitor is coupled to a second voltage supply, and in the third state the first terminal of the first capacitor is floating;
a second capacitor (950) having a first terminal and a second terminal the second terminal being connected to the output;
a second circuit (Fig. 8) connected to the first terminal of the second capacitor, **characterized in that** a time delay separates a first onset of a first boosting operation of the first circuit and a second onset of a second boosting operation of the second circuit;
the first circuit being operable to cause the first boosting operation to boost the output from the precharge level (1105) to a first voltage level (1110), the second circuit being operable to cause the second boosting operation to boost the output from the first voltage level to a second voltage level (1120) having a greater magnitude than the first voltage level;
the first circuit being operable to switch to the third state upon onset of the second boosting operation so as to isolate the first circuit from the output.

2. The boost circuit of claim 1, wherein one of the first voltage supply and the second voltage supply is ground (625).

3. The boost circuit of claim 1, wherein the precharge circuit comprises:
a switching circuit (650) having at least a first switching terminal and a second switching terminal, and the first switching terminal coupled to the output,
and the second switching terminal coupled to one of the first voltage
supply and the second voltage supply.

4. The boost circuit of claim 1, wherein the first terminal (725) of the first capacitor switches among the first state, the second state, and the third state in response to at least one of a first signal (606) and a second signal (608).

5. The boost circuit of claim 4, wherein the first terminal of the first capacitor switches to the first state in response to both the first signal and the second signal.

6. The boost circuit of claim 4, wherein the first terminal of the first capacitor switches to the second state in response to the first signal.

7. The boost circuit of claim 4, wherein the first terminal of the first capacitor switches to the third state in response to both the first signal and the second signal.

8. An integrated circuit device, comprising:
a substrate (1200);
a boost circuit (1204) as claimed in any preceding claim, the boost circuit being provided on the substrate..

9. An integrated circuit device, comprising:
a substrate (1200);
a memory array (1201) on the substrate, and the memory array having memory cells;
a plurality of word lines (1214) coupled to memory cells in the memory array;
a boost circuit (1204) as claimed in any of claims 1 to 7, the boost circuit being provided on the substrate, the output (550) being coupleable to one or more of a plurality of word line drivers (1205).

10. A method of reducing energy consumption of a boost circuit, the boost circuit comprising:
a first capacitor (740) having a first terminal and a second terminal, and the second terminal connected to an output (550);
a first circuit (Fig. 7) connected to the first terminal of the first capacitor, the first circuit defining one of a first state, a second state, and a third state,
wherein in the first state the first terminal of the first capacitor is coupled to a first voltage supply, and in the second state the first terminal of the first capacitor is coupled to a second voltage supply, and in the third state the first terminal of the first capacitor is floating;
a second capacitor (950) having a first terminal and a second terminal;
a second circuit (Fig. 8) connected to the first terminal of the second capacitor, the second terminal of the second capacitor being connected to the output;
the method comprising the steps of:
precharging the output to a precharge level (1105);
providing a time delay separating a first onset of a first boosting operation of the first circuit and a second onset of a second boosting operation of the second circuit;
performing the first boosting operation of the first circuit to boost the output from the precharge level (1105) to a first voltage level (1110);
performing the second boosting operation of the second circuit to boost the output from the first voltage level to a second voltage level (1120) having a greater magnitude than the first voltage level; and
switching the first circuit to the third state upon onset of the second boosting operation so as to isolate the first circuit from the output.

## Patentansprüche

1. Verstärkerschaltkreis, welcher aufweist:
einen Ausgang (550),
einen Vorladeschaltkreis (Figur 6), der mit dem Ausgang verbunden und in der Weise betreibbar ist, daß er den Ausgang auf ein Vorladeniveau (1105) vorlädt,
einen ersten Kondensator (740), der einen ersten Anschluß und einen zweiten Anschluß hat, wobei der zweite Anschluß mit dem Ausgang verbunden ist,
einen ersten Schaltkreis (Figur 7), der mit dem ersten Anschluß des ersten Kondensators verbunden ist, wobei der erste Schaltkreis entweder einen ersten Zustand, einen zweiten Zustand oder einen dritten Zustand definiert, wobei im ersten Zustand der erste Anschluß des ersten Kondensators mit einer Versorgungsspannung verbunden ist und in dem zweiten Zustand der erste Anschluß des ersten Kondensators mit einer dritten Versorgungsspannung verbunden ist und in dem dritten Zustand der erste Anschluß des ersten Kondensators potentialfrei (floating) ist,
einen zweiten Kondensator (950), der einen ersten Anschluß und einen zweiten Anschluß hat, wobei der zweite Anschluß mit dem Ausgang verbunden ist,
einen zweiten Schaltkreis (Figur 8), der mit dem ersten Anschluß des zweiten Kondensators verbunden ist,
**dadurch gekennzeichnet, daß** eine Zeitverzögerung das erste Einsetzen eines ersten Verstärkungsvorgangs des ersten Schaltkreises und ein zweites Einsetzen eines zweiten Verstärkungsvorgangs des zweiten Schaltkreises trennt,
wobei der erste Schaltkreis in der Weise betreibbar ist, daß er bewirkt, daß der erste Verstärkungsvorgang den Ausgang von dem Vorladeniveau (1105) auf ein erstes Spannungsniveau (1110) verstärkt, der zweite Schaltkreis in der Weise betreibbar ist, daß er bewirkt, daß der zweite Verstärkungsvorgang den Ausgang von dem ersten Spannungsniveau auf ein zweites Spannungsniveau (1120) verstärkt, welches einen größeren Wert hat als das erste Spannungsniveau,
wobei der erste Schaltkreis in der Weise betreibbar ist, daß er beim Einsetzen des zweiten Verstärkungsvorgangs in den dritten Zustand umschaltet, um so den ersten Schaltkreis von den Ausgängen zu isolieren.

2. Verstärkungsschaltkreis nach Anspruch 1, wobei entweder die erste Versorgungsspannung oder die zweite Versorgungsspannung Masse (625) ist.

3. Verstärkungsschaltkreis nach Anspruch 1, wobei der Vorladeschaltkreis aufweist:
einen Umschalterkreis (650), der zumindest einen ersten Umschaltanschluß und einen zweiten Umschaltanschluß hat, und wobei der erste Umschaltanschluß mit dem Ausgang verbunden ist und der zweite Umschaltanschluß entweder mit der ersten Spannungsversorgung oder mit der zweiten Spannungsversorgung verbunden ist.

4. Verstärkerschaltkreis nach Anspruch 1, wobei der erste Anschluß (725) des ersten Kondensators in Reaktion auf zumindest ein erstes Signal (606) und/oder ein zweites Signal (608) zwischen dem ersten Zustand, dem zweiten Zustand und dem dritten Zustand umschaltet.

5. Verstärkungsschaltkreis nach Anspruch 4, wobei der erste Anschluß des ersten Kondensators in Reaktion auf sowohl das erste als auch das zweite Signal in den ersten Zustand umschaltet.

6. Verstärkungsschaltkreis nach Anspruch 4, wobei der erste Anschluß des ersten Kondensators in Reaktion auf das erste Signal in den zweiten Zustand umschaltet.

7. Verstärkungsschaltkreis nach Anspruch 4, wobei der erste Anschluß des ersten Kondensators in Reaktion auf sowohl das erste als auch das zweite Signal in den dritten Zustand umschaltet.

8. Integrierte Schaltkreiseinrichtung, welche aufweist:
ein Substrat (1200),
einen Verstärkerschaltkreis (1204), wie er in einem der vorstehenden Ansprüche beansprucht wurde, wobei der Verstärkerschaltkreis auf dem Substrat vorgesehen ist.

9. Integrierte Schaltkreiseinrichtung, welche aufweist:
ein Substrat (1200),
ein Speicherarray (1201) auf dem Substrat, wobei das Speicherarray Speicherzellen hat,
eine Mehrzahl von Wortleitungen (1214), die mit den Speicherzellen in dem Speicherarray verbunden sind, einen Verstärkerschaltkreis (1204) nach einem der Ansprüche 1 bis 7, wobei der Verstärkerschaltkreis auf dem Substrat vorgesehen ist und der Ausgang (550) mit einem oder mehreren aus einer Mehrzahl von Wortleitungstreibern (1205) verbindbar ist.

10. Verfahren zum Reduzieren des Energieverbrauchs eines Verstärkerschaltkreises, wobei der Verstärkerschaltkreis aufweist:
einen ersten Kondensator (740), der einen ersten Anschluß und einen zweiten Anschluß hat, und wobei der zweite Anschluß mit einem Ausgang (550) verbunden ist,
einen ersten Schaltkreis (Figur 7), der mit dem ersten Anschluß des ersten Kondensators verbunden ist, wobei der erste Schaltkreis zumindest einen ersten Zustand oder einen zweiten Zustand oder einen dritten Zustand definiert,
wobei in dem ersten Zustand der erste Anschluß des ersten Kondensators mit einer ersten Spannungsversorgung verbunden ist und in dem zweiten Zustand der erste Anschluß des ersten Kondensators mit einer zweiten Spannungsversorgung verbunden ist und in dem dritten Zustand der erste Anschluß des ersten Kondensators potentialfrei (floating) ist,
einen zweiten Kondensator (950), der einen ersten Anschluß und einen zweiten Anschluß hat,
einen zweiten Schaltkreis (Figur 8), der mit dem ersten Anschluß des zweiten Kondensators verbunden ist, wobei der zweite Anschluß des zweiten Kondensators mit dem Ausgang verbunden ist,
wobei das Verfahren die Schritte aufweist:
Vorladen des Ausgangs auf ein Vorladeniveau (1105),
Bereitstellen einer Zeitverzögerung, welche ein erstes Einsetzen eines ersten Verstärkungsvorgangs des ersten Schaltkreises und ein zweites Einsetzen eines zweiten Verstärkungsvorgangs des zweiten Schaltkreises voneinander trennt,
Durchführen des ersten Verstärkungsvorgangs des ersten Schaltkreises, um den Ausgang von dem Vorladeniveau (1105) auf ein erstes Spannungsniveau (1110) zu verstärken,
Ausführen des zweiten Verstärkungsvorgangs des zweiten Schaltkreises, um den Ausgang von dem ersten Spannungsniveau auf ein zweites Spannungsniveau (1120) zu verstärken, das größer bzw. höher ist als das erste Spannungsniveau, und
Umschalten des ersten Schaltkreises in den dritten Zustand beim Einsetzen des zweiten Verstärkungsvorgangs, um auf diese Weise den ersten Schaltkreis von dem Ausgang zu isolieren.

## Revendications

1. Circuit d'amplification, comprenant :
une sortie (550) ;
un circuit de précharge (figure 6) relié à la sortie et pouvant être mis en oeuvre pour précharger la sortie à un niveau de précharge (1105) ;
un premier condensateur (740) ayant une première borne et une seconde borne, et la seconde borne étant reliée à la sortie ;
un premier circuit (figure 7) relié à la première borne du premier condensateur, le premier circuit définissant l'un d'un premier état, d'un deuxième état et d'un troisième état, dans lesquels, dans le premier état, la première borne du premier condensateur est reliée à une première alimentation en tension, et dans le deuxième état, la première borne du premier condensateur est reliée à une seconde alimentation en tension, et dans le troisième état, la première borne du premier condensateur est flottante ;
un second condensateur (950) ayant une première borne et une seconde borne, la seconde borne étant reliée à la sortie ;
un second circuit (figure 8) relié à la première borne du second condensateur, **caractérisé en ce qu'**une temporisation sépare un premier début d'une première opération d'amplification du premier circuit et un second début d'une seconde opération d'amplification du second circuit ;
le premier circuit pouvant être mis en oeuvre pour amener la première opération d'amplification à amplifier la sortie depuis le niveau de précharge (1105) jusqu'à un premier niveau de tension (1110), le second circuit pouvant être mis en oeuvre pour amener la seconde opération d'amplification à amplifier la sortie depuis le premier niveau de tension jusqu'à un second niveau de tension (1120) ayant une amplitude plus grande que le premier niveau de tension ;
le premier circuit pouvant être mis en oeuvre pour commuter au troisième état lors du début de la seconde opération d'amplification de façon à isoler le premier circuit de la sortie.

2. Circuit d'amplification selon la revendication 1, dans lequel l'une de la première alimentation en tension et de la seconde alimentation en tension est la masse (625).

3. Circuit d'amplification selon la revendication 1, dans lequel le circuit de précharge comprend :
un circuit de commutation (650) ayant au moins une première borne de commutation et une seconde borne de commutation, et la première borne de commutation étant reliée à la sortie, et la seconde borne de commutation étant reliée à l'une de la première alimentation en tension et de la seconde alimentation en tension.

4. Circuit d'amplification selon la revendication 1, dans lequel la première borne (725) du premier condensateur commute entre le premier état, le deuxième état, et le troisième état en réponse à au moins un d'un premier signal (606) et d'un second signal (608).

5. Circuit d'amplification selon la revendication 4, dans lequel la première borne du premier condensateur commute vers le premier état en réponse à la fois au premier signal et au second signal.

6. Circuit d'amplification selon la revendication 4, dans lequel la première borne du premier condensateur commute vers le deuxième état en réponse au premier signal.

7. Circuit d'amplification selon la revendication 4, dans lequel la première borne du premier condensateur commute vers le troisième état en réponse à la fois au premier signal et au second signal.

8. Dispositif à circuit intégré, comprenant :
un substrat (120a) ;
un circuit d'amplification (1204) selon l'une quelconque des revendications précédentes, le circuit d'amplification étant disposé sur le substrat.

9. Dispositif à circuit intégré, comprenant :
un substrat (1200) ;
une matrice mémoire (1201) sur le substrat, et la matrice mémoire possédant des cellules de mémoire
une pluralité de lignes de mots (1214) reliées à des cellules de mémoire dans la matrice mémoire ;
un circuit d'amplification (1204) selon l'une quelconque des revendications 1 à 7, le circuit d'amplification étant disposé sur le substrat, la sortie (550) pouvant être reliée à un ou plusieurs circuits d'une pluralité de circuits de pilotage de ligne de mots (1205).

10. Procédé de réduction de la consommation d'énergie d'un circuit d'amplification, le circuit d'amplification comprenant :
un premier condensateur (740) ayant une première borne et une seconde borne, et la seconde borne étant reliée à une sortie (550) ;
un premier circuit (figure 7) relié à la première borne du premier condensateur, le premier circuit définissant l'un d'un premier état, d'un deuxième état et d'un troisième état, dans lesquels, dans le premier état, la première borne du premier condensateur est reliée à une première alimentation en tension, et dans le deuxième état, la première borne du premier condensateur est reliée à une seconde alimentation en tension, et dans le troisième état, la première borne du premier condensateur est flottante
un second condensateur (950) ayant une première borne et une seconde borne ;
un second circuit (figure 8) relié à la première borne du second condensateur, la seconde borne du second condensateur étant reliée à la sortie ;
le procédé comprenant les étapes consistant à :
précharger la sortie à un niveau de précharge (1105) ;
fournir une temporisation séparant un premier début d'une première opération d'amplification du premier circuit et un second début d'une seconde opération d'amplification du second circuit ;
effectuer la première opération d'amplification du premier circuit pour amplifier la sortie depuis le niveau de précharge (1105) jusqu'à un premier niveau de tension (1110) ;
effectuer la seconde opération d'amplification du second circuit pour amplifier la sortie depuis le premier niveau de tension jusqu'à un second niveau de tension (1120) ayant une amplitude supérieure au premier niveau de tension ; et
commuter le premier circuit vers le troisième état lors du début de la seconde opération d'amplification de façon à isoler le premier circuit de la sortie.
